(19) **Europäisches Patentamt**
**European Patent Office**
**Office européen des brevets**

(11) Publication number: **0 167 271**
**A2**

(12) # EUROPEAN PATENT APPLICATION

(21) Application number: **85303789.3**

(22) Date of filing: **30.05.85**

(51) Int. Cl.⁴: **G 11 C 17/00**

(30) Priority: **31.05.84 JP 109425/84**

(43) Date of publication of application:
**08.01.86 Bulletin 86/2**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Sato, Shinji c/o FUJITSU LIMITED**
**Patent Department 1015 Kamikodanaka**
**Nakahara-ku Kawasaki-shi Kanagawa 211(JP)**

(74) Representative: **Sunderland, James Harry et al,**
**HASELTINE LAKE & CO Hazlitt House 28 Southampton**
**Buildings Chancery Lane**
**London WC2A 1AT(GB)**

(54) Semiconductor read only memory device.

(57) A semiconductor ROM device which stores information in the form of a one-out-of-n type signal, thereby drastically decreasing the number of memory cells in the device. Bit lines are grouped into bit line groups (A,B,C,D) each including a plurality of bit lines (B1...B16), (B17...B32), (B33...B48), (B49...B64). For each set of cross points of a word line with a bit line group, one FET ($Q_{11}$, $Q_{12}$...$Q_{43}$) is allotted. The drain of the FET (e.g. $Q_{11}$) is connected selectively to one of the bit lines (e.g. B1...B16). If there are n bit lines, there are n ways of connecting each FET. Therefore each FET can store n kinds of information in one-out-of-n fashion. When stored information is read out, it is converted back to binary signals by built-in multi-base-to-binary converters (D1,D2,D3,D4).

EP 0 167 271 A2

Croydon Printing Company Ltd.

./...

# FIG. 5

SEMICONDUCTOR READ ONLY MEMORY DEVICE

This invention relates to a semiconductor read only memory (ROM) device.

In a typical ROM device, information is stored in a memory cell array. Each memory cell of the array stores only one bit and at least one transistor is required for each cell and hence for each bit.

With increasing memory size, the number of transistors in memory devices is also increasing and the packing density of transistors in memory device ICs (integrated circuits) is increasing.

Occasionally it can happen, particularly when a quantity of ROMs to be used for a special purpose is so small that it is not cost-effective to design a new ROM, that an IC chip which is not especially designed as a ROM device is used as a ROM, i.e. as a substitutional ROM. For example, a master slice chip designed primarily for providing logic circuits such as NAND or NOR circuits may be used to provide a substitutional ROM device. In such a case the transistors fabricated in the chip are not intended for memory use, and their sizes and positions in the chip are not suited to a ROM, so the chip size of such a substitutional ROM becomes unreasonably large.

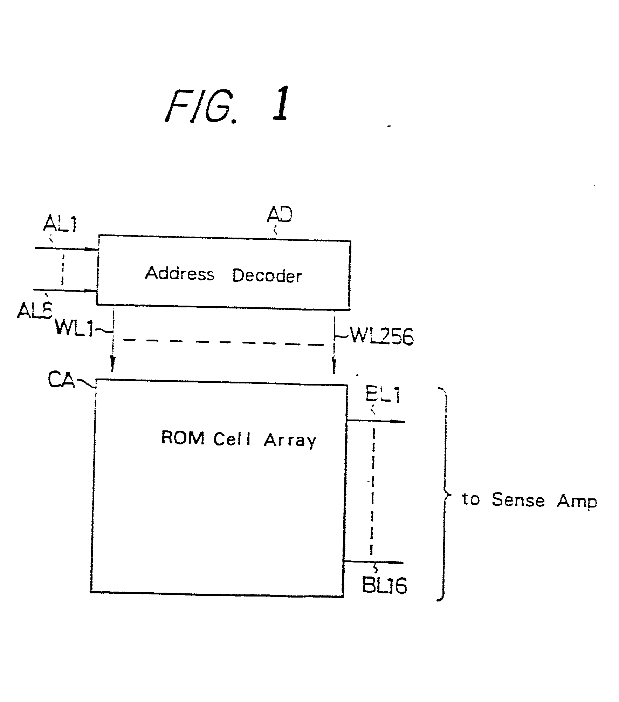

An exemplary construction and operation of a prior art ROM will be described briefly with reference to Fig.1, which is a block diagram of a conventional 4Kbit wired ROM. In the Figure, AD is an address decoder, and CA is a cell array which is composed of memory cells arranged in an array.

The address decoder AD shown in the Figure has eight address bit input lines AL1-AL8 for inputting an 8 bit address input signal and 256 output lines WL1-WL256, for designating $2^8=256$ addresses. The output lines extend to the cell array CA as 256 word lines, corresponding respectively to the 256 addresses, and the cell array has 16 bit lines BL1-BL16 for outputting 16 bit data signals. At each cross point of a word line and a bit line a memory cell is provided. Therefore, there are 256x16=4096 memory cells altogether. Further details of these circuit elements are omitted for the sake of simplicity, since they are all conventional.

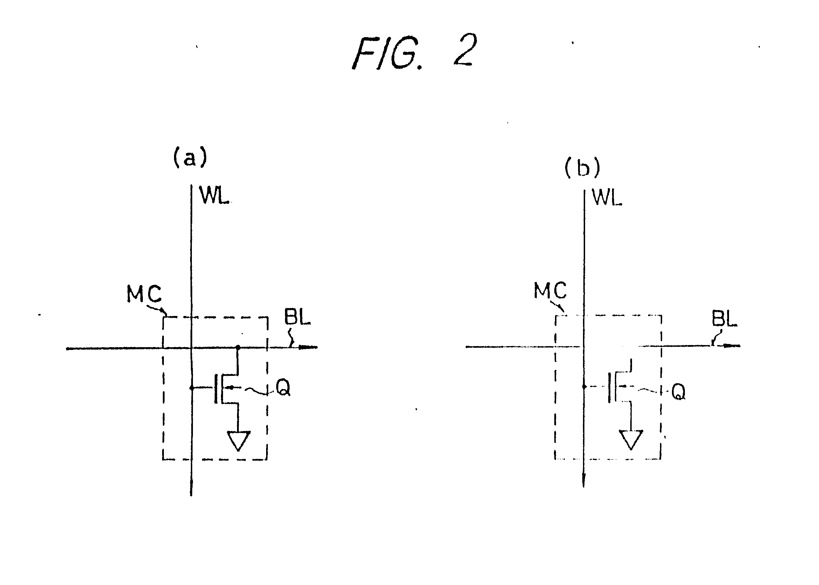

Fig.2 illustrates a typical ROM memory cell composed of a single field effect transistor (FET), showing how such a memory cell MC (surrounded by a broken line rectangle) can be wired in the ROM to memorize a "0" or a "1" bit. In the Figure, WL is a word line, BL is a bit line and Q is an n-channel FET.

In Fig.2, (a) shows wiring for memorizing a "0" bit in the memory cell MC, wherein the drain of the n-channel FET Q is connected to the bit line BL. In Fig.2, (b) shows wiring for memorizing a "1" bit in the memory cell MC, wherein the drain of the n-channel FET Q is disconnected from the bit line BL. In both cases, the source of the n-channel FET Q is connected to the negative side of a supply voltage source, as indicated by an overturned triangle in the Figure; usually this is ground. The gate of each FET is connected commonly to a respective word line of a column in the cell array. Such connection or disconnection of (drain) wiring is effected, according to information to be stored in the ROM, during its fabrication.

In order to read out information stored in the ROM, a word line selected by the address decoder is pulled up to a high level (H) by a signal from the address decoder. At the same time, the bit lines are also pulled up. However, a bit line which has a memory cell wired as in Fig.2(a) is connected to negative side (ground) through the FET Q, so the output (bit line level) is "0" (low level L). On the other hand, a bit line which is connected to a memory cell wired as in Fig.2(b) outputs "1" (high level H). Such outputs (bit line levels) are detected by sense amplifiers (not shown) and the stored information is read out.

The correspondence of L or H levels to "0" or "1" bits is simply a matter of convention, and the correspondence may be reversed. In the explanation hereinafter, it will be assumed that L and H correspond respectively to "0" and "1". Also, although the above explanation has been given with respect to a memory cell which is switched by an n-channel FET, it will be clear that the memory cell may be switched by any type of switching means, including a p-channel FET or other type of transistor.

Of course there are various types of memory cell which comprise more than one transistor, but it will be clear from the above explanation that at least one transistor has been required to memorize one bit in a ROM. Therefore, as the memory size becomes large it has been inevitable that the chip size becomes large or the packing density of transistors in the chip becomes high.

According to the present invention, there is provided a semiconductor read only memory device, comprising

a plurality of bit line groups each comprising a plurality of bit lines,

a plurality of word lines arranged cross-wise with respect to the bit lines, to form sets of cross points, each set corresponding to the crossing of a respective bit line group by a respective word line, and

a plurality of switching means, corresponding respectively to the sets of cross points, each arranged so as to turn on or off in dependence upon the level of the word line forming the corresponding set of cross points and each selectively connected and/or selectively not connected to the bit lines of the bit line group forming the corresponding set of cross points.

According to the present invention there is provided a semiconductor read only memory device, comprising:

a plurality of bit line groups each comprising a plurality of bit lines;

a plurality of word lines arranged cross-wise with respect to the bit lines to form sets of cross points, each set corresponding to the crossing of a respective bit line group by a respective word line; and

a plurality of switching means, corresponding respectively to the sets of cross points, arranged so as to turn on or off in dependence upon signals from the word lines, and each being connected to one of the bit lines of the bit line group forming the corresponding set of cross points, in order to store a plurality of bits of information in correspondence to one switching means.

An embodiment of the present invention can effectively increase the bit number (number of bits) which can be stored in a memory cell and relieve the increase of size or packing density of devices in a ROM.

An embodiment of the present invention employs a memory cell structure such as to be applicable for a substitutional memory device which utilizes a chip not designed for use as a ROM, a master slice device for example.

An embodiment of the present invention can provide a memory which stores information to be stored in a form of one-out-of-n signals, and sends out stored information after conversion to binary signals at read out time.

In an embodiment of the present invention, a semiconductor ROM device stores information to be stored in the form of a one-out-of-n signal. When the stored signal is read out, it sends out the signal after converting it back to binary base signal.

In contrast to known ROM devices whose memory cells each correspond to only one bit line, in accordance with an embodiment of the present invention each memory cell corresponds to a plurality of bit lines. Such a plurality of bit lines is here referred to as a bit line group. In this embodiment, the one switching element (e.g. transistor) in each memory cell is selectively connected to one of the bit lines of the corresponding bit line group. Thus, in each memory cell the switching element can be connected in a plurality of ways to the relevant bit line group. In this way, it is possible to store more than one bit of information in the memory cell.

If a bit line group has n bit lines available to be selected by the switching element in a memory cell, the memory cell can store any of n units of information in one-out-of-n fashion. In other words, there can be enabled the storage of a plurality of digits of a binary signal in the form of one digit of an n-base numeral signal. When stored information is read out, it is converted to a binary signal by built-in decoders, and output from the ROM.

This can not only reduce problems of increase of size or packing density of devices in ROM, but is useful also for realizing a custom designed ROM circuit in small quantities by utilizing a substitutional chip, a gate array chip for example.

Reference is made, by way of example, to the accompanying drawings, in which:

Fig.1 is a block diagram of a conventional prior art ROM device;

Fig.2 is a schematic circuit diagram showing a main part of a memory cell, wherein (a) illustrates how a "0" bit is stored and (b) illustrates how a "1" bit is stored in the memory cell;

Fig.3 is a schematic block diagram of an embodiment of ROM device in accordance with the present invention;

Fig.4 is a schematic circuit diagram showing a main part of a memory cell in accordance with an embodiment of the present invention, illustrating how a single memory cell can store a hexadecimal digit;

Fig.5 is a schematic circuit diagram illustrating an example of wiring of a memory array of a ROM in accordance with an embodiment of the present invention, illustrating how hexadecimal digits may be stored in the ROM;

Fig.6 is a schematic circuit diagram showing a main part of a decoder used in the embodiment of Fig.3, illustrating how decoder cells are connected to bit lines; and

Fig.7 is a schematic circuit diagram illustrating how decoder cells of Fig.6 may be wired, (a) showing wiring of a decoder cell used for a connection not marked with a circle in Fig.6, and (b) showing wiring of a decoder cell used for a connection which is marked with a circle in Fig.6.

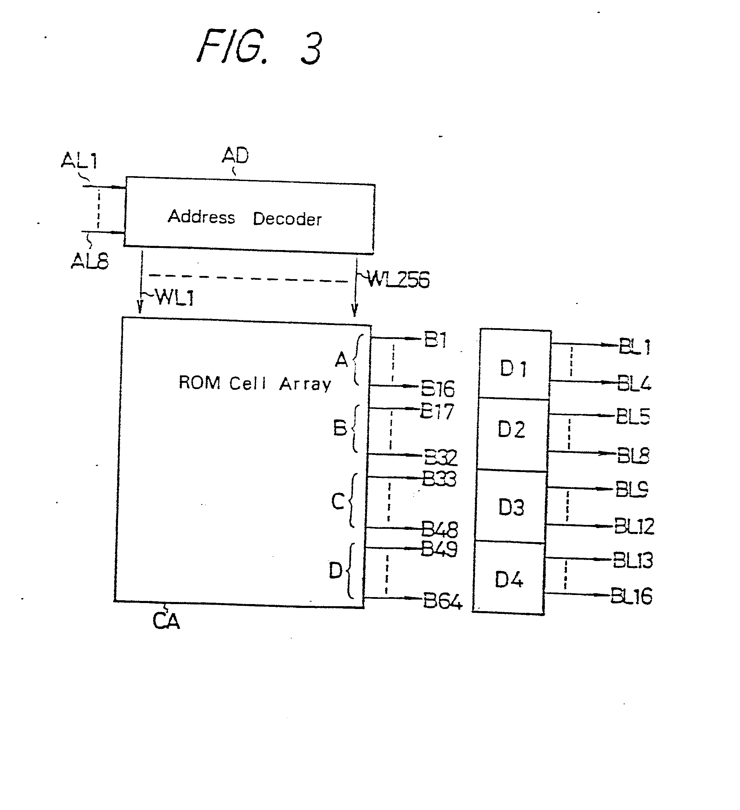

Fig.3 is a block diagram of a ROM device in accordance with an embodiment of the present invention. An address decoder AD of the ROM device may be similar to a known address decoder, having eight address bit input lines AL1-AL8 and 256 output lines WL1-WL256. Similarly to the device of Fig.1, these 256 output lines extend as word lines to a cell array CA. In contrast to the device of Fig.1 however, the cell array CA of the present embodiment has 64 bit lines, arranged across the word lines, grouped into four bit line groups A,B,C and D, each group including 16 bit lines. That is, bit line group A has 16 bit lines B1-B16, and similarly the bit line groups B,C and D have bit lines B17-B32, B33-B48 and B49-B64 respectively.

The 16 bit lines of the bit line group A are connected to a decoder D1. Similarly, each of the bit line groups B, C and D is connected to a respective decoder D2, D3 and D4 as shown in Fig.3. Each of these decoders converts an input signal of a one-out-of-16 type to a binary signal of four bits, and outputs the bits of this binary signal respectively to four output bit lines. That is, the decoder D1 converts its input signal from 16-bit-line group B1-B16 into a four bit binary signal and outputs it on four output bit lines BL1-BL4. Similarly, the decoders D2, D3 and D4 convert their input signals from respective 16-bit-line groups to binary signals of four bits and output these binary signals to output bit lines BL5-BL8, BL9-BL12 and BL13-BL16 respectively. Consequently, a binary signal of 16 bits altogether is output from output bit lines BL1-BL16.

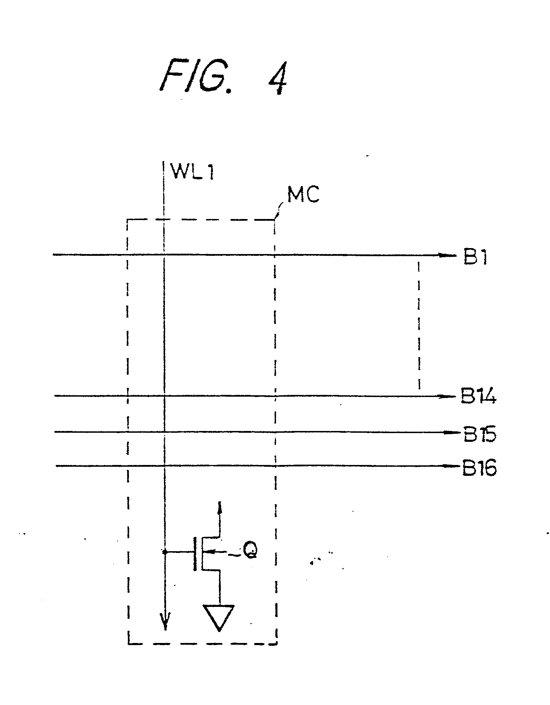

Fig.4 shows schematically a main part of a memory cell in the embodiment of Fig.3. In contrast to the ordinary memory cell of Fig.2, only one FET Q is allotted for all the cross points of one word line with 16 bit lines. The gate of the FET Q is connected to the word line WL1 for example, but the drain of Q is selectively connected to one of the 16 bit lines B1-B16 for example. This connection is made according to the information to be stored in the ROM.

Since there are 16 $(=2^4)$ ways of connection for the FET Q, this means that the single FET Q in Fig.4 can store a 4 bit signal. This is equivalent to storing 4 bits of a binary signal into one memory cell in the form of a one-out-of-n signal. Or, it may be considered that a four bit binary signal is stored in a memory cell as one hexadecimal digit.

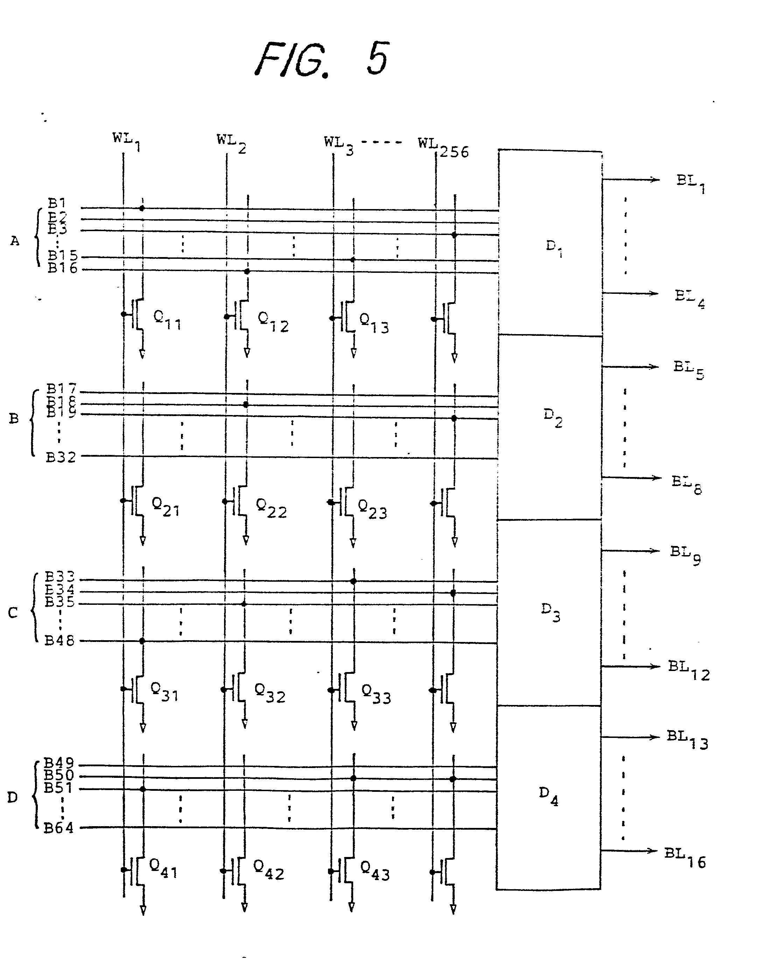

Fig.5 shows a part of cell array CA in Fig.3, illustrating an example of wiring of the memory cells.

In respect of each columnar word line (WL1-WL256) four FETs are provided whose gates are connected to the respective word line (e.g. for word line WL1, FET's $Q_{11}$, $Q_{21}$, $Q_{31}$, $Q_{41}$ are provided, and for word line WL3, FET's $Q_{13}$, $Q_{23}$, $Q_{33}$, $Q_{43}$ are provided). These FETs are assumed to be n-channel FETs hereinafter. Each FET has its source connected to a negative side voltage supply line (generally ground). The drain of each FET is connected selectively to one of the 16 bit lines in the bit line group to which the FET is allotted, and these connections are made according to the information to be stored in the cell array. For example, transistor $Q_{13}$ of bit line group A and word line WL3 in the embodiment of Fig.5 is connected to a bit line B15, and disconnected from all other 15 bit lines. This is a one-out-of-16 connection. If the word line WL3 and the bit lines of group A are pulled up (the stored memory is read out), the output signals on the 16 bit lines B1-B16 will become (1111111111111101), denoting the 15th digit or character in hexadecimal notation (usually expressed as "E") corresponding to the binary signal (1110).

As has been described above, each transistor in the memory cell array is connected to one of 16 bit lines. (It should be pointed out that in Fig.5 there are some transistors which appear to be unconnected to any bit lines, for example transistors $Q_{21}$, $Q_{23}$ and $Q_{42}$ etc., but these transistors are in fact connected each to one bit line. The connections are omitted from the Figure for simplicity). Thus, each memory cell in the embodiment of Fig.5 can store any one of 16 items of information, or the value of one hexadecimal digit, corresponding to the values of four binary bits, with only one FET.

When the information stored in such a manner is read out it is converted to a binary signal by decoders

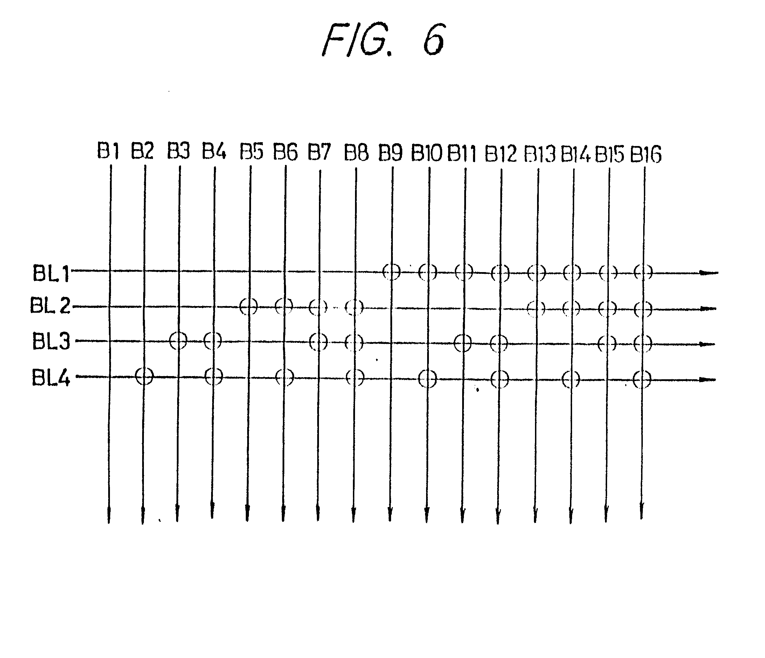

D1 to D4, and sent out. Each decoder has 16 input lines and four output bit lines (BL1-BL4, BL5-BL8, BL9-BL12, BL13-BL16) arranged crosswise of the input lines (see Fig.6). Each input line of a decoder is connected to a respective bit line of a corresponding bit line group as shown in Fig.5. Each decoder can be considered to be a multi-base-to-binary converter (in the above embodiment, a hexadecimal-to-binary converter) or as a ROM which stores the 16 different possible values of a four bit binary numeral in 16 addresses. Explanation of these decoders will be given with respect to D1; the other decoders D2, D3 and D4 have similar configuration. Similarly to an ordinary ROM, at each cross point of an input line B1-B16 (which input lines may be considered as decoder word lines for the purpose of this explanation) and an output bit line BL1-BL4, an FET is provided. Therefore, altogether 4x16=64 FETs are provided. These FETs are connected in a similar manner to those of Fig.1. Namely, the gates of each four FETs belonging to a respective input line are connected commonly to the input line. Connection of the drain of each FET to a respective output bit line BL1-BL4 is determined by a conversion rule for converting hexadecimal digits (values) to binary digits (values).

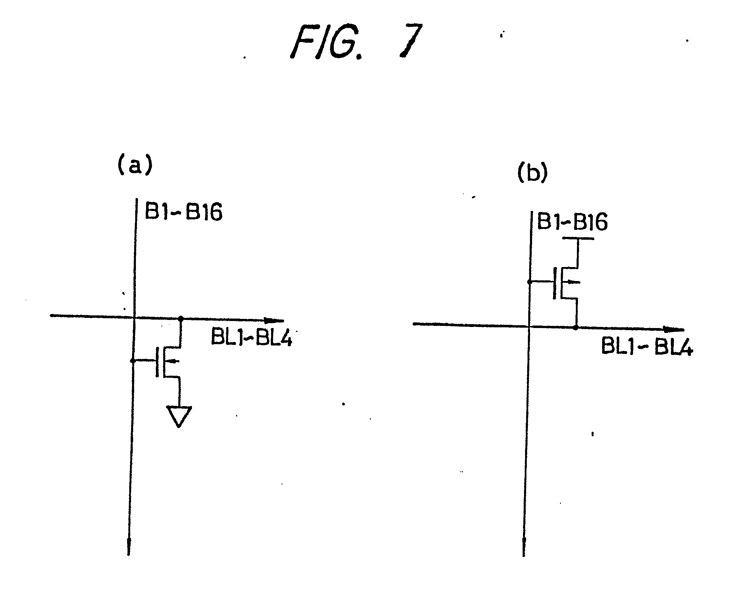

Fig.6 is a diagram illustrating schematically an example of internal connections in the decoder D1 of Fig.3. There are 16x4=64 cross points of input lines B1-B16 and output bit lines BL1-BL4. As can be seen in the Figure, small circles are marked on half of the cross points. It will be noticed that the arrangements of the circles on the input line correspond to the 16 different possible values of a 4-bit binary number. Each cross point which is not marked with a circle is provided with an n-channel FET, and each cross point which is marked with a circle is provided with a p-channel FET. The n-channel FETs are connected respectively as shown in Fig.7(a), and the p-channel FETs are connected respectively as shown in Fig.7(b). The drains of these FETs are connected to the output bit lines. The source of each n-channel FET is connected to the negative side of a voltage source, and the source of each p-channel FET is connected to the positive side of the voltage source. The gates of these FETs are connected to respective input bit lines.

When the input lines of the output bit lines are pulled up to high voltage level H, a cross point as shown in Fig.7(a) outputs L level ("0"), and a cross point as shown in Fig.7(b) outputs H level ("1"). Therefore, when an input bit line is selected and pulled up to read out the memory, an output bit line which is not marked with a circle in Fig.6 will provide an output signal of "0", and an output bit line which is marked with a circle will provide an output signal of "1".

Consider a case for example in which the input bit line BL5 is selected in a manner such as described before. Then from Fig.6, the output signals on the output bit lines BL1-BL4 will become (1110). Thus, the stored signal in the memory cell Q13 in the example of Fig.5 has been read out. Likewise the remaining signals stored in $Q_{23}$, $Q_{33}$ and $Q_{43}$ may be read out to provide outputs respectively on the output bit lines BL5-BL8, BL9-BL12 and BL13-BL16. Thus the 16 bit signal stored in word line WL3 may be read out.

It will be clear from the above description how, in an embodiment of the present invention, 16 kinds of signals are stored and read out. By doing so, the number of transistors necessary in the memory array can be decreased to 1/4 of the number in previous devices. The description has been made with respect to a 4k ROM with an 8 bit address input and 16 bit data output, but it will be understood that the present invention can be applied to any scale of ROM device, and it will also be understood that the advantages of the present invention will increase as the scale of integration of a ROM becomes larger. Moreover, the circuit elements which may be used in embodiments of the present invention are not limited to those in the above description. for example, the address decoder AD and the decoders D1-D4 may be of any widely used type, hence the internal connections of the decoders are not limited to those shown in Fig.6. Of course, the switching elements provided at each cross point of the bit lines and the word lines may be any type of switching device including transistors.

Finally, the overall merit of a ROM device in accordance with an embodiment of the present invention will be considered. In the above embodiment, the number of transistors in the memory cell array CA is decreased from 256x16 to 256x4, which is a greatly advantageous reduction by a factor of four in the number of transistors. On the other hand, the number of output bit lines is increased from 16 to 64, that is an increase of four times, and output decoders D1-D4 (which have altogether 4x16x4=256 transistors) and wiring for them must be added. Though these factors to some extend detract from the advantage of the present invention, the total number of transistors may be decreased to less than 1/3, and the chip size for the above embodiment of 4k ROM may be decreased by one half.

The present invention is most advantageous when applied to a ROM to be made in relatively small quantities, so that it is not worth while fabricating a new custom chip. For such purpose, a proper (appropriate) size of master slice may be used as a substitutional ROM. By a known method for a 4k ROM for example, a chip having more than 4000 transistors (256x16) must be used but if an embodiment of the present invention is applied, a chip having only approximately 1300 (256x5) transistors may be applicable. Therefore, freedom of selection of the chip becomes very wide, and consequently, the size of the ROM can be reduced greatly.

Another merit of a ROM device in accordance with an embodiment of the present invention appears in read out time. If the number of memory cells in a ROM device is reduced by a factor of 1/n, the side length of the cell array, hence the length of the wiring, may be reduced to $1/\sqrt{n}$. So, the readout time can be reduced, since read out time depends on the line length of wiring in the memory cell array.

Still another merit of a ROM device in accordance with an embodiment of the present invention stems from the fact that the cell array area is separated from a sense amplifier area (which is not shown in the Figure) by decoders. Testing of the device, therefore, can be carried out separately upon those small separated areas, and it becomes easy and simple to test the device.

As has been described above, in accordance with an embodiment of the present invention a ROM device can memorize binary signal information by converting it to a one-out-of-n type signal, or in other words by converting multidigit information of binary base numerals to one digit of higher base numerals. By doing so the number of memory cells in a ROM device can be reduced. Though the explanation has been carried on using a hexadecimal digit, any base digit can be used. The higher base digit is used, the more memory cells may be reduced. However, it should be pointed out that, as the higher base digit is used the number of output bit lines (BL1-BL16 in the above embodiment) increases. The output decoders (D1-D4) also increase in complexity. There must be therefore, a compromise between them. From the experience of the inventor, the use of hexadecimal digits (one out of sixteen type signal) as has been described with respect to the above embodiment is a very practical one.

CLAIMS

1.     A semiconductor read only memory device, comprising

a plurality of bit line groups each comprising a plurality of bit lines,

a plurality of word lines arranged cross-wise with respect to the bit lines, to form sets of cross points, each set corresponding to the crossing of a respective bit line group by a respective word line, and

a plurality of switching means, corresponding respectively to the sets of cross points, each arranged so as to turn on or off in dependence upon the level of the word line forming the corresponding set of cross points and each selectively connected and/or selectively not connected to the bit lines of the bit line group forming the corresponding set of cross points.

2.     A semiconductor read only memory device, comprising:

a plurality of bit line groups each comprising a plurality of bit lines;

a plurality of word lines arranged cross-wise with respect to the bit lines to form sets of cross points, each set corresponding to the crossing of a respective bit line group by a respective word line; and

a plurality of switching means, corresponding respectively to the sets of cross points, arranged so as to turn on or off in dependence upon signals from the word lines, and each being connected to one of the bit lines of the bit line group forming the corresponding set of cross points, in order to store a plurality of bits of information in correspondence to one switching means.

3.     A device according to claim 1 or 2, further comprising output decoders connected respectively to the said bit line groups, for decoding information carried on said bit lines into binary signals.

4.      A device according to claim 1, 2 or 3, further comprising an address decoder arranged for receiving an address input signal and for providing an addressing signal to said word lines.

5.      A device according to claim 1, 2, 3, or 4 wherein each of the switching means comprise a field effect transistor the gate of which is connected to a word line, and the drain of which is connected to one of the bit lines of the bit line group forming the set of cross points corresponding to the switching means, so as to store information as a one-out-of-n type signal.

6.      A device according to claim 3, or either of claims 4 and 5 when read as appended to claim 3, wherein said output decoders are multi-base-to-binary converters.

7.      A device according to claim 3 or 6, wherein said output decoders are means for converting one-out-of-n signals to binary signals.

8.      A device according to claim 3 or 6 when read as appended to claim 2, wherein said plurality of bits of information is stored as one hexadecimal digit and said output decoders are hexadecimal-to-binary decoders.

# FIG. 1

# FIG. 2

(a)

(b)

# FIG. 3

# FIG. 4

5/7

FIG. 5

FIG. 6

# FIG. 7

(a)

B1–B16

BL1–BL4

(b)

B1–B16

BL1–BL4